# EUROPEAN PATENT APPLICATION

(11) **EP 4 618 593 A1**
(43) Date of publication of application: **17.09.2025**
(21) Application number: 23909370.1
(22) Date of filing: 19.09.2023
(51) Int. Cl.: H04R 3/12

(54) **AUDIO CIRCUIT AND TERMINAL DEVICE**

(30) Priority: 29.12.2022 CN 202223603010 U
(71) Applicant: Honor Device Co., Ltd., Shenzhen, Guangdong 518040 (CN)
(72) Inventor: ZHANG, Lixin, Shenzhen, Guangdong 518040 (CN)
(74) Representative: Goddar, Heinz J.
(86) International application number: PCT/CN2023/119725
(87) International publication number: WO 2024/139435

(57) **Abstract**

Embodiments of this application provide an audio circuit and a terminal device. The circuit includes a battery, a controller, a first power amplifier, a switching unit, a first speaker, and a second speaker. Input ends of the battery and the switching unit are both connected to the first power amplifier. A first output end and a second output end of the switching unit are respectively connected to the first speaker and the second speaker. The controller is connected to the switching unit. The first speaker and the second speaker do not simultaneously operate. The battery is configured to supply power to the first power amplifier. The first power amplifier is configured to amplify audio. The switching unit is configured to select to connect to the first speaker, or to select to connect to the second speaker. The controller is configured to control selection switching of the switching unit. The first speaker and the second speaker are both configured to play audio processed by the first power amplifier. In this way, the speakers that do not simultaneously make sounds share one power amplifier, thereby reducing a quantity of power amplifiers, and reducing costs and an occupied area of the circuit.

## Description

This application claims priority to Chinese Patent Application No. 202223603010.3, filed with China National Intellectual Property Administration on December 29, 2022 and entitled "AUDIO CIRCUIT AND RELATED APPARATUS", which is incorporated herein by reference in its entirety.

### TECHNICAL FIELD

This application relates to the field of terminal technologies, and in particular, to an audio circuit and a terminal device.

### BACKGROUND

With the continuous development of technologies, electronic devices are updated more and more quickly. Audio performance, as an important performance indicator of the electronic devices, is also a key area of focus for technological development and update.

The electronic device may improve, through a smart power amplifier (smart power amplifier, smart PA) and a speaker (speak, SPK), a series of performance such as loudness and sound quality of audio played externally by the electronic device.

However, when there are a plurality of speakers in a terminal device, costs of the terminal device are high.

### SUMMARY

Embodiments of this application provide an audio circuit and a terminal device. Speakers that do not simultaneously make sounds are connected to a same smart PA, thereby reducing a quantity of smart PAs in the terminal device, and reducing a size and costs of the terminal device.

According to a first aspect, an embodiment of this application provides an audio circuit. The audio circuit includes a battery, a controller, a first power amplifier, a switching unit, a first speaker, and a second speaker. The battery is connected to the first power amplifier. An input end of the switching unit is connected to the first power amplifier. The first speaker is connected to a first output end of the switching unit. The second speaker is connected to a second output end of the switching unit. The controller is connected to the switching unit. The first speaker and the second speaker do not simultaneously operate. The battery is configured to supply power to the first power amplifier. The first power amplifier is configured to amplify audio. The switching unit is configured to select to connect to the first power speaker and the first speaker, or to select to connect to the first power amplifier and the second speaker. The controller is configured to control selection switching of the switching unit. The first speaker is configured to play audio processed by the first power amplifier. The second speaker is configured to play the processed audio.

In this embodiment of this application, the power amplifier may be a smart power amplifier or the like. In this way, the speakers that do not simultaneously make sounds are connected to the same power amplifier, thereby reducing a quantity of power amplifiers in the circuit, and reducing a size and costs of the circuit.

Optionally, when the audio is a prompt tone, a video, or music, the controller is specifically configured to control the switching unit to select to connect to the first power amplifier and the first speaker; or when the audio is audio corresponding to a private call, the controller is specifically configured to control the switching unit to select to connect to the first power amplifier and the second speaker.

Optionally, the switching unit includes a first MOS transistor and a second MOS transistor, where the first MOS transistor is connected to the first speaker, and the second MOS transistor is connected to the second speaker. The controller is specifically configured to control the first MOS transistor to be turned on, and to control the second MOS transistor to be turned off, to select to connect to the first speaker. Alternatively, the controller is specifically configured to control the first MOS transistor to be turned off, and to control the second MOS transistor to be turned on, to select to connect to the second speaker.

In this way, the switching of two speakers of the power amplifier can be implemented through the MOS transistors.

Optionally, the switching unit includes a first switch and a second switch, where two ends of the first switch are respectively connected to the first power amplifier and the first speaker, and two ends of the second switch are respectively connected to the first power amplifier and the second speaker. The controller is specifically configured to control the first switch to be turned on, and to control the second switch to be turned off, to select to connect to the first speaker. Alternatively, the controller is specifically configured to control the first switch to be turned off, and to control the second switch to be turned on, to select to connect to the second speaker.

The first switch and the second switch each may be a single-pole single-throw switch, or another type of switch. This is not limited herein. In this way, the switching of two speakers can be implemented through two switches.

Optionally, the switching unit includes a third switch, where the third switch includes a first port, a second port, and a third port, the first port is connected to the first power amplifier, the second port is connected to the first speaker, and the third port is connected to the second speaker. The controller is specifically configured to control the first port to be connected to the second port, to select to connect to the first speaker. Alternatively, the controller is specifically configured to control the first port to be connected to the third port, to select to connect to the second speaker.

The third switch may be a single-pole double-throw switch, or another type of switch. This is not limited herein. The first port corresponds to the input end, the second port corresponds to the first output end, and the third port corresponds to the second output end. In this way, the switching of two speakers can be implemented through one switch.

Optionally, the controller is specifically configured to send a first signal to the switching unit when receiving a first message; and the switching unit is specifically configured to select to connect to the first speaker when receiving the first signal. Alternatively, the controller is specifically configured to send a second signal to the switching unit when receiving a second message; and the switching unit is specifically configured to select to connect to the second speaker when receiving the second signal.

The first signal and the second signal each may be an enabling signal. This is not limited herein. In this way, connection switching is controlled through different enabling signals, and a control manner is simple and easy to implement.

Optionally, the first message indicates to play a prompt tone, a video, or music; and the second message indicates audio corresponding to a private call.

Optionally, the controller is further configured to send the first signal to the first power amplifier; and the first power amplifier is further configured to adjust an audio gain of the first power amplifier to a first gain when receiving the first signal, where the first gain corresponds to the first speaker. Alternatively, the controller is further configured to send the second signal to the first power amplifier; and the first power amplifier is further configured to adjust an audio gain of the first power amplifier to a second gain when receiving the second signal, where the second gain corresponds to the first speaker.

In this way, the controller may further adjust a setting item of the first power amplifier through the first signal and the second signal, to adapt to different speakers.

Optionally, the first power amplifier includes a first pin and a second pin. The first pin is connected to the input end of the switching unit, and the first output end and the second output end are respectively connected to a positive electrode of the first speaker and a positive electrode of the second speaker. The second pin is connected to a negative electrode of the first speaker. The second pin is connected to a negative electrode of the second speaker.

In this embodiment of this application, the first pin corresponds to an OUTN pin, and the second pin corresponds to an OUTP pin. The switching unit may be disposed between the positive electrode of the speaker and the first power amplifier.

Optionally, the first power amplifier includes a third pin and a fourth pin. The third pin is connected to the input end of the switching unit, and the first output end and the second output end are respectively connected to the negative electrode of the first speaker and the negative electrode of the second speaker. The fourth pin is connected to the positive electrode of the first speaker. The second pin is connected to the positive electrode of the second speaker.

In this embodiment of this application, the third pin corresponds to the OUTN pin, and the fourth pin corresponds to the OUTP pin. The switching unit may be disposed between the negative electrode of the speaker and the first power amplifier.

Optionally, the circuit further includes a second power amplifier and a third speaker. The battery and the third speaker are both connected to the second power amplifier. The second power amplifier is configured to amplify the audio. The third speaker is configured to play audio processed by the second power amplifier.

In this way, a terminal device may have a plurality of speakers and use a plurality of playing manners, thereby improving a playing effect.

Optionally, the first speaker is located on a first side of a terminal device, the third speaker is located on a second side of the terminal device, the first side and the second side are two opposite sides, and the second speaker is located behind a display of the terminal device.

The first speaker may be located at the bottom of the terminal device, and the third speaker may be located at the top of the terminal device.

According to a second aspect, an embodiment of this application provides a terminal device. The terminal device includes: a mobile phone (mobile phone), a tablet computer, a palmtop computer, a notebook computer, a mobile Internet device (mobile Internet device, MID), a wearable device, a virtual reality (virtual reality, VR) device, an augmented reality (augmented reality, AR) device, a wireless terminal in industrial control (industrial control), a wireless terminal in self-driving (self driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device or another processing device connected to a wireless modem, an in-vehicle device, a wearable device, a terminal device in a 5G network or a terminal device in a future evolved public land mobile network (public land mobile network, PLMN), and the like.

The terminal device includes the audio circuit in the first aspect.

Optionally, the terminal device further includes a microphone, where the microphone is configured to collect a sound signal.

For beneficial effects of the terminal device provided in the second aspect and all possible designs of the second aspect, refer to beneficial effects brought by the first aspect and all possible apparatuses of the first aspect. Details are not described herein again.

### BRIEF DESCRIPTION OF DRAWINGS

FIG. 1 is a diagram of a structure of an audio circuit in a possible design;
FIG. 2 is a diagram of a structure of an audio circuit according to an embodiment of this application;
FIG. 3 is a diagram of a structure of a switching unit according to an embodiment of this application; and
FIG. 4 is diagrams of structures of a smart PA and a switching unit according to an embodiment of this application.

### DESCRIPTION OF EMBODIMENTS

To clearly describe the technical solutions in embodiments of this application, terms such as "first" and "second" are used in embodiments of this application to distinguish between same items or similar items that provide basically same functions or purposes. For example, a first chip and a second chip are merely used to distinguish between different chips, and are not intended to limit a sequence thereof. A person skilled in the art may understand that the terms such as "first" and "second" do not limit a quantity or an execution sequence, and the terms such as "first" and "second" do not indicate a definite difference.

It should be noted that in embodiments of this application, the word "example", "for example", or the like is used to represent giving an example, an illustration, or a description. Any embodiment or design scheme described as an "example" or "for example" in this application should not be explained as being more preferred or having more advantages than another embodiment or design scheme. To be precise, the word such as "example" or "for example" is intended to present a related concept in a specific manner.

In embodiments of this application, "at least one" means one or more, and "a plurality of" means two or more. The term "and/or" describes an association relationship for describing associated objects and represents that three relationships may exist. For example, A and/or B may represent the following three cases: Only A exists, both A and B exist, and only B exists, where A and B may be singular or plural. The character "/" generally indicates an "or" relationship between the associated objects. "At least one of the following items (pieces)" or a similar expression thereof means any combination of these items, including a singular item (piece) or any combination of plural items (pieces). For example, at least one of a, b, or c may represent: a, b, c, a-b, a-c, b-c, or a-b-c, where a, b, and c may be singular or plural.

A terminal device in embodiments of this application may be any form of electronic device. For example, the electronic device may include a handheld device having an image processing function, an in-vehicle device, and the like. For example, some electronic devices are a mobile phone (mobile phone), a tablet computer, a palmtop computer, a notebook computer, a mobile Internet device (mobile Internet device, MID), a wearable device, a virtual reality (virtual reality, VR) device, an augmented reality (augmented reality, AR) device, a wireless terminal in industrial control (industrial control), a wireless terminal in self-driving (self driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device or another processing device connected to a wireless modem, an in-vehicle device, a wearable device, a terminal device in a 5G network or a terminal device in a future evolved public land mobile network (public land mobile network, PLMN), and the like. This is not limited in embodiments of this application.

As an example rather than a limitation, in embodiments of this application, the electronic device may alternatively be a wearable device. The wearable device may also be referred to as a wearable intelligent device, and is a collective term for wearable devices that are intelligently designed and developed for daily wear by using a wearable technology, for example, glasses, gloves, watches, clothes, and shoes. The wearable device is a portable device that is directly worn on a body or integrated into clothes or an accessory of a user. The wearable device is not merely a hardware device, but is used to implement a powerful function through software support, data exchange, and cloud interaction. Generalized wearable intelligent devices include full-function and large-size devices that can implement complete or partial functions without depending on smartphones, for example, smart watches or smart glasses, and include devices that focus on a specific type of application function and need to be used together with other devices such as smartphones, for example, various smart bands or smart jewelry for monitoring physical signs.

In addition, in embodiments of this application, the electronic device may alternatively be a terminal device in an Internet of things (Internet of things, IoT) system. The IoT is an important part in future development of information technologies, and is mainly technically characterized in that things are connected to networks through communication technologies, to achieve intelligent networks of human-machine interconnection and interconnection between things.

The electronic device in embodiments of this application may also be referred to as: a terminal device, user equipment (user equipment, UE), a mobile station (mobile station, MS), a mobile terminal (mobile terminal, MT), an access terminal, a user unit, a user station, a mobile site, a mobile station, a remote station, a remote terminal, a mobile device, a user terminal, a terminal, a wireless communication device, a user agent, a user apparatus, or the like.

In embodiments of this application, the electronic device or each network device includes a hardware layer, an operating system layer running above the hardware layer, and an application layer running above the operating system layer. The hardware layer includes hardware such as a central processing unit (central processing unit, CPU), a memory management unit (memory management unit, MMU), and a memory (which is also referred to as a main memory). The operating system may be any one or more computer operating systems for implementing service processing through a process (process), for example, a Linux operating system, a Unix operating system, an Android operating system, an iOS operating system, or a Windows operating system. The application layer includes applications such as a browser, an address book, text processing software, and instant messaging software.

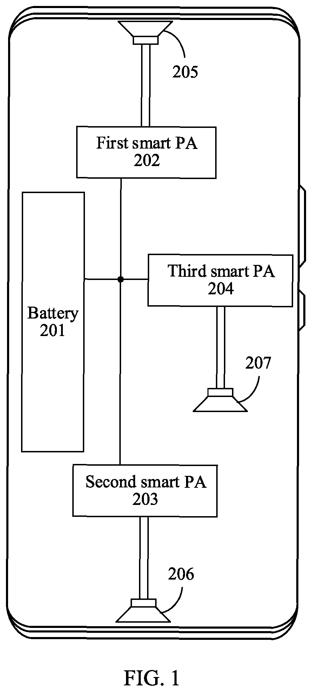

The following describes a structure of an audio circuit in a possible design with reference to FIG. 1.

For example, FIG. 1 is a diagram of a structure of an audio circuit in a possible design. An example in which a mobile phone includes three speakers, and the mobile phone is powered by one battery is used for description. In actual application, two or more speakers may alternatively be disposed in the mobile phone. Details are not described herein again.

As shown in FIG. 1, the mobile phone includes a battery 201, a first smart PA 202, a second smart PA 203, a third smart PA 204, a first speaker 205, a second speaker 206, and a third speaker 207.

Input ends of the first smart PA 202, the second smart PA 203, and the third smart PA 204 are all connected to the battery 201. An output end of the first smart PA 202 is connected to the first speaker 205, an output end of the second smart PA 203 is connected to the second speaker 206, and an output end of the third smart PA 204 is connected to the third speaker 207.

It should be noted that the smart PA is also essentially a power amplifier, and has a feedback function compared with a common power amplifier. The smart PA can specifically improve a dynamic sound output range, dynamically track a status of the speaker and sense a change in an environment in which the speaker is located, and provide a change after adaptation. In a possible implementation, a characteristic change of the speaker is related to a frequency/impedance curve. The smart PA can measure output voltage and current in real time, to calculate the frequency/impedance curve of the speaker. The smart PA can calculate a current amplitude of the speaker based on a pre-established algorithm and a preset algorithm parameter, and can predict a future amplitude of the speaker by calculating an input signal. This can effectively adjust performance of the speaker, for example, increasing a volume, and improving sound quality.

It can be seen from FIG. 1 that a terminal device drives three speakers respectively through three smart PAs, that is, each speaker is correspondingly connected to one smart PA.

However, this causes high costs of the terminal device.

In some embodiments, the first speaker is located at the top of the terminal device, the second speaker is located at the bottom of the terminal device, and the third speaker is located behind a display of the terminal device.

It may be understood that the terminal device may control the first speaker, the second speaker, or the third speaker to separately make sounds. The terminal device may alternatively control the first speaker and the third speaker to simultaneously make sounds. The terminal device may alternatively control the second speaker and the third speaker to simultaneously make sounds. For example, when playing music, a video, or a prompt tone, the terminal device may control the first speaker and the third speaker to simultaneously make sounds. When making a private call, the terminal device may control the second speaker and the third speaker to simultaneously make sounds.

However, the terminal device does not control the second speaker and the third speaker to simultaneously make sounds, that is, there is no scenario in which the second speaker and the third speaker simultaneously make sounds.

In view of this, an embodiment of this application provides an audio circuit in which speakers that do not simultaneously make sounds share one smart PA, to reduce the use of the smart PA, and reduce hardware costs of the terminal device.

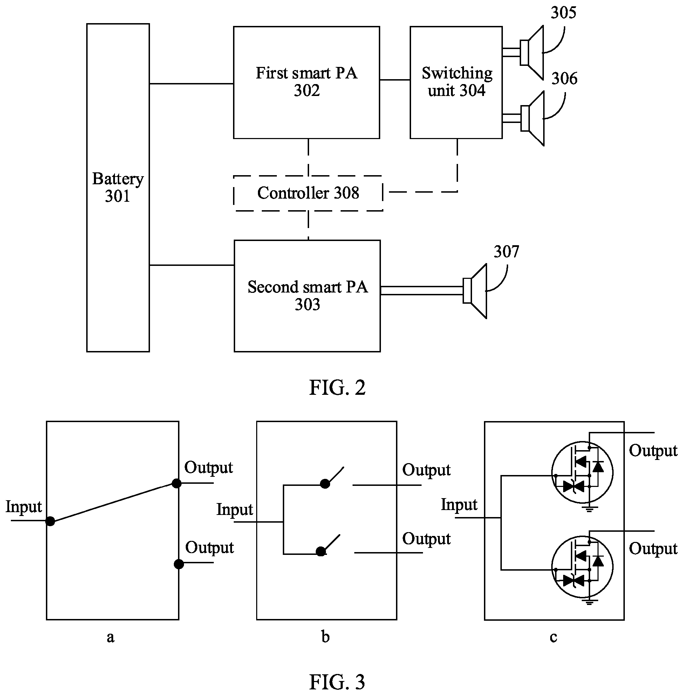

For example, FIG. 2 is a diagram of a structure of an audio circuit according to an embodiment of this application. An example in which a mobile phone includes three speakers, and the mobile phone is powered by one battery is used for description. In actual application, two or more speakers may alternatively be disposed in the mobile phone. Details are not described herein again.

As shown in FIG. 2, the mobile phone includes a battery 301, a first smart PA 302, a second smart PA 303, a switching unit 304, a first speaker 305, a second speaker 306, and a third speaker 307.

Input ends of the first smart PA 302 and the second smart PA 303 are both connected to the battery 301. An output end of the first smart PA 302 is connected to an input end of the switching unit 304. A first output end and a second output end of the switching unit 304 are respectively connected to the first speaker 305 and the second speaker 306, and an output end of the second smart PA 303 is connected to the third speaker 307.

The battery 301 is configured to supply power to the first smart PA 302 and/or the second smart PA 303.

The first smart PA 302 is configured to amplify audio, and transmit processed audio through the switching unit 304 to the first speaker 305 for play or to the second speaker 306 for play.

The second smart PA 303 is configured to amplify audio, and transmit processed audio through the switching unit 304 to the third speaker 307 for play.

The first smart PA 302 and the second smart PA 303 may further be configured to adjust a dynamic audio output range.

The switching unit 304 is configured to select to connect to the first speaker 305, or to select to connect to the second speaker 306.

The switching unit 304 may include one switch (as shown in a in FIG. 3), may include two switches (as shown in b in FIG. 3), or may include two metal oxide semiconductor field-effect transistors (metal oxide semiconductor field-effect transistors, MOS transistor) (as shown in c in FIG. 3). A specific structure of the switching unit 304 is not limited in this embodiment of this application.

In this embodiment of this application, the MOS transistor may be an N-type MOS transistor, or may be a P-type MOS transistor. This is not specifically limited herein.

It may be understood that the switching unit 304 and the first smart PA 302 may be separately disposed. The switching unit 304 and the first smart PA 302 may alternatively be integrated together. If the switching unit 304 and the first smart PA 302 are separately disposed, the first smart PA 302 and the second smart PA 303 have a same structure, and share one design, which facilitates production. If the switching unit 304 and the first smart PA 302 are integrated together, sizes of the first smart PA 302 and the switching unit 304 are reduced, and an occupied area is reduced, which helps miniaturize a terminal device.

In this embodiment of this application, the first speaker 305, the second speaker 306, and the third speaker 307 may be speakers of a same type, or may be speakers of different types. This is not specifically limited herein.

It may be understood that, if the first speaker 305 and the second speaker 306 are speakers of different types, configuration items of the first smart PA 302 for the first speaker 305 are different from those for the second speaker 306. For example, loudness of the first speaker 305 is different from that of the second speaker 306; and a gain of the first speaker 305 is different from that of the second speaker 306.

In this way, two speakers may share one smart PA, which can reduce the use of the smart PA, and reduce hardware costs.

In some embodiments, the first speaker and the second speaker are respectively located at the bottom of the terminal device and behind a display. The third speaker is located at the top of the terminal device.

In some embodiments, the audio circuit further includes a controller 308. The controller 308 is connected to the switching unit 304. The controller 308 is configured to control selection switching of the switching unit 304.

In this embodiment of this application, the controller may be a processor, or may be another type of controller. The processor may be a system on chip (system on chip, SOC), a micro control unit (micro control unit, MCU), or the like. A specific structure of the controller is not limited in this embodiment of this application.

In this embodiment of this application, the controller 308 may control selection switching of the switching unit 304 through an enabling signal or in any other manner.

For example, an example in which the switching unit 304 is a single-pole double-throw switch (as shown in a in FIG. 3) is used. When receiving a message for indicating the first speaker to play, the controller sends a first enabling signal to the switching unit 304; and in response to the first enabling signal, the input end of the switching unit 304 is connected to the first output end of the switching unit 304. When receiving a message for indicating the second speaker to play, the controller sends a second enabling signal to the switching unit; and in response to the second enabling signal, the input end of the switching unit 304 is connected to the second output end of the switching unit 304.

For example, an example in which the switching unit 304 includes two switches (as shown in b in FIG. 3) is used. When receiving a message for indicating the first speaker to play, the controller sends a first enabling signal to the switching unit 304; and in response to the first enabling signal, a first switch in the switching unit 304 is turned on, and a second switch in the switching unit 304 is turned off. When receiving a message for indicating the second speaker to play, the controller sends a second enabling signal to the switching unit; and in response to the second enabling signal, the first switch in the switching unit 304 is turned off, and the second switch in the switching unit 304 is turned on.

For example, an example in which the switching unit 304 includes two MOS transistors (as shown in c in FIG. 3) is used. When receiving a message for indicating the first speaker to play, the controller sends a first enabling signal to the switching unit 304; and in response to the first enabling signal, a first MOS transistor in the switching unit 304 is turned on, and a second MOS transistor in the switching unit 304 is turned off. When receiving a message for indicating the second speaker to play, the controller sends a second enabling signal to the switching unit; and in response to the second enabling signal, the first MOS transistor in the switching unit 304 is turned off, and the second MOS transistor in the switching unit 304 is turned on.

In some embodiments, the controller is further configured to control whether the second smart PA 303 operates.

The following describes a control method for the audio circuit shown in FIG. 2.

When receiving a first message for indicating the first speaker to play, the controller transmits the first enabling signal to the switching unit 304; and after receiving the first enabling signal, the switching unit 304 controls the first smart PA 302 to be connected to the first speaker 305, to play audio through the first speaker 305. The controller further transmits the first enabling signal to the first smart PA 302; and after receiving the first enabling signal, the first smart PA 302 adjusts the configuration items of the first smart PA 302 based on the first speaker 305. The configuration items may be a gain, loudness, and the like of the audio.

When receiving a second message for indicating the second speaker to play, the controller transmits the second enabling signal to the switching unit 304; and after receiving the second enabling signal, the switching unit 304 controls the first smart PA 302 to be connected to the second speaker 306, to play audio through the second speaker 306. The controller further transmits the second enabling signal to the first smart PA 302; and after receiving the second enabling signal, the first smart PA 302 adjusts the configuration items of the first smart PA 302 based on the second speaker 306.

When receiving a third message for indicating the third speaker to play, the controller transmits a third enabling signal to the second smart PA 303; and after receiving the third enabling signal, the second smart PA 303 controls the third speaker 307 to play audio.

It may be understood that, when music and a ring tone is played, the controller may simultaneously receive the first message and the third message. When a user uses the terminal device to make a private call, the user may simultaneously receive the second message and the third message.

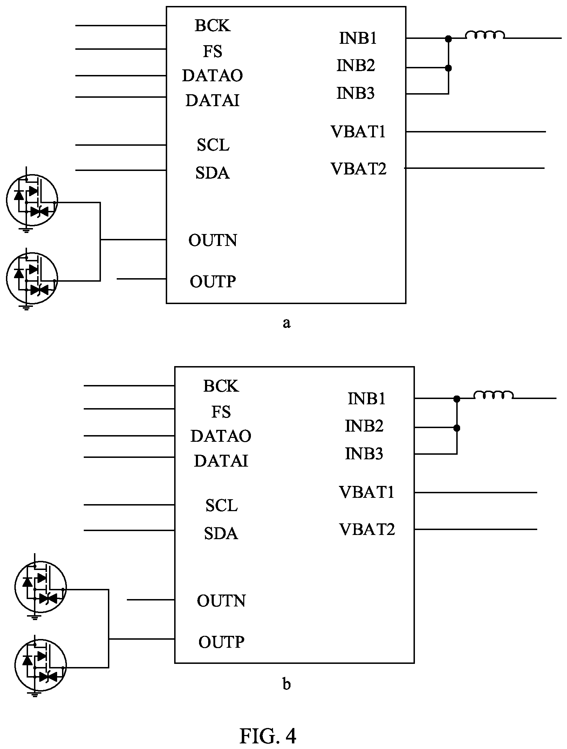

For example, FIG. 4 is diagrams of structures of a first smart PA and a switching unit according to an embodiment of this application. As shown in FIG. 4, the first smart PA includes a plurality of pins. The plurality of pins are respectively an INB 1 pin, an INB2 pin, an INB3 pin, an FS pin, a DATAO pin, a DATAI pin, an SCL pin, an SDA pin, an OUTN pin, and an OUTP pin.

The INB1 pin, the INB2 pin, and the INB3 pin are all connected to a battery. The INB1 pin, the INB2 pin, and the INB3 pin are used for voltage input of audio amplification. The OUTN pin and the OUTP pin are used for output of audio amplification.

In this embodiment of this application, the switching unit may be disposed at the OUTN pin, or may be disposed at the OUTP pin. This is not limited herein.

As shown in a in FIG. 4, the OUTN pin is connected to an input end of the switching unit, and a first output end of the switching unit is connected to a positive electrode of a first speaker. A second output end of the switching unit is connected to a positive electrode of a second speaker. The OUTP pin is connected to a negative electrode of the first speaker. The OUTP pin is connected to a negative electrode of the second speaker.

As shown in b in FIG. 4, the OUTP pin is connected to the input end of the switching unit, and the first output end of the switching unit is connected to the negative electrode of the first speaker. The second output end of the switching unit is connected to the negative electrode of the second speaker. The OUTN pin is connected to the positive electrode of the first speaker. The OUTN pin is connected to the positive electrode of the second speaker.

The FS pin, the DATAO pin, the DATAI pin, the SCL pin, and the SDA pin are all connected to a controller. The FS pin is used for synchronous input of a digital audio frame in an I2S interface. The DATAO pin is used for output of digital audio data in the I2S interface. The DATAI pin is used for input of the digital audio data in the I2S interface. The SCL pin is used for clock input on a digital I2C bus. The SDA pin is used for data input/output on the digital I2C bus.

It may be understood that the controller may transmit audio data through an I2S connection line, and adjust an audio data gain of a smart PA through the I2C bus.

In some embodiments, a VBAT1 pin and a VBAT2 pin are further included. The VBAT1 pin and the VBAT2 pin are both connected to the battery. The VBAT1 pin and the VBAT2 pin (not shown in the figure) are used for voltage detection.

In some other embodiments, the VBAT1 pin and the VBAT2 pin are both connected to a voltage module ((not shown in the figure), and are used to detect voltage of the voltage module. The VBAT1 pin and the VBAT2 pin are not connected to the battery. In this way, a voltage detected by the smart PA is greater than an under voltage lock out (UVLO) threshold, thereby reducing a case in which the smart PA does not operate.

Voltage output by the battery enters the smart PA from the INB1 pin, the INB2 pin, and the INB3 pin. Amplified audio is output from the OUTN pin and the OUTP pin to the speaker.

It may be understood that, in the structure shown in FIG. 4, voltage detection is performed through two pins (the VBAT1 pin and the VBAT2 pin). Alternatively, only one pin or another quantity of pins may be disposed in the smart PA for voltage detection. This is not limited in this embodiment of this application.

An embodiment of this application further provides a terminal device. The terminal device includes the audio circuit in the foregoing embodiment.

Optionally, the terminal device further includes a microphone, where the microphone is configured to collect a sound signal.

For example, the terminal device may include: a processor, an external memory interface, an internal memory, a universal serial bus (universal serial bus, USB) interface, a charging management module, a power management unit, a battery, an antenna, a mobile communication module, a wireless communication module, an audio module (including the audio circuit), a speaker, a receiver, a microphone, a headset jack, a sensor module, a key, a motor, an indicator, a camera, a display, a subscriber identity module (subscriber identification module, SIM) card interface, and the like. The sensor module may include a pressure sensor, a gyroscope sensor, a barometric pressure sensor, a magnetic sensor, an acceleration sensor, a distance sensor, an optical proximity sensor, a fingerprint sensor, a temperature sensor, a touch sensor, an ambient light sensor, a bone conduction sensor, and the like. The terminal device may include more or fewer components than those shown in the figure, or some components may be combined, or some components may be split, or there may be a different component layout. The components shown in the figure may be implemented by hardware, software, or a combination of software and hardware. This is not limited herein.

It should be noted that user information (including but not limited to user device information, user personal information, and the like) and data (including but not limited to data for analysis, stored data, displayed data, and the like) in this application are all information and data authorized by users or fully authorized by all parties, the collection, use, and processing of related data need to comply with related laws, regulations, and standards of related countries and regions, and corresponding operation access needs to be provided for the users to choose to authorize or reject.

The objectives, technical solutions, and benefits of this application are further described in detail in the foregoing specific embodiments. It should be understood that the foregoing descriptions are merely specific embodiments of this application, but are not intended to limit the protection scope of this application. Any modification, equivalent replacement or improvement made based on the technical solutions in this application shall fall within the protection scope of this application.

## Claims

1. An audio circuit, comprising a battery, a controller, a first power amplifier, a switching unit, a first speaker, and a second speaker, wherein
the battery is connected to the first power amplifier, an input end of the switching unit is connected to the first power amplifier, the first speaker is connected to a first output end of the switching unit, the second speaker is connected to a second output end of the switching unit, the controller is connected to the switching unit, and the first speaker and the second speaker do not simultaneously operate;
the battery is configured to supply power to the first power amplifier;
the first power amplifier is configured to amplify audio;
the switching unit is configured to select to connect to the first power amplifier and the first speaker, or to select to connect to the first power amplifier and the second speaker;
the controller is configured to control selection switching of the switching unit;
the first speaker is configured to play audio processed by the first power amplifier; and
the second speaker is configured to play the processed audio.

2. The circuit according to claim 1, wherein when the audio is a prompt tone, a video, or music, the controller is specifically configured to control the switching unit to select to connect to the first power amplifier and the first speaker; or
when the audio is audio corresponding to a private call, the controller is specifically configured to control the switching unit to select to connect to the first power amplifier and the second speaker.

3. The circuit according to claim 1 or 2, wherein the switching unit comprises a first MOS transistor and a second MOS transistor, wherein the first MOS transistor is connected to the first speaker, and the second MOS transistor is connected to the second speaker; and
the controller is specifically configured to control the first MOS transistor to be turned on, and to control the second MOS transistor to be turned off, to select to connect to the first speaker; or
the controller is specifically configured to control the first MOS transistor to be turned off, and to control the second MOS transistor to be turned on, to select to connect to the second speaker.

4. The circuit according to claim 1 or 2, wherein the switching unit comprises a first switch and a second switch, wherein two ends of the first switch are respectively connected to the first power amplifier and the first speaker, and two ends of the second switch are respectively connected to the first power amplifier and the second speaker;
the controller is specifically configured to control the first switch to be turned on, and to control the second switch to be turned off, to select to connect to the first speaker; or
the controller is specifically configured to control the first switch to be turned off, and to control the second switch to be turned on, to select to connect to the second speaker.

5. The circuit according to claim 1 or 2, wherein the switching unit comprises a third switch, wherein the third switch comprises a first port, a second port, and a third port, the first port is connected to the first power amplifier, the second port is connected to the first speaker, and the third port is connected to the second speaker; and
the controller is specifically configured to control the first port to be connected to the second port, to select to connect to the first speaker; or
the controller is specifically configured to control the first port to be connected to the third port, to select to connect to the second speaker.

6. The circuit according to any one of claims 1 to 5, wherein
the controller is specifically configured to send a first signal to the switching unit when receiving a first message; and
the switching unit is specifically configured to select to connect to the first speaker when receiving the first signal; or
the controller is specifically configured to send a second signal to the switching unit when receiving a second message; and
the switching unit is specifically configured to select to connect to the second speaker when receiving the second signal.

7. The circuit according to any one of claims 1 to 6, wherein
the controller is further configured to send the first signal to the first power amplifier; and
the first power amplifier is further configured to adjust an audio gain of the first power amplifier to a first gain when receiving the first signal, wherein the first gain corresponds to the first speaker; or
the controller is further configured to send the second signal to the first power amplifier; and
the first power amplifier is further configured to adjust an audio gain of the first power amplifier to a second gain when receiving the second signal, wherein the second gain corresponds to the second speaker.

8. The circuit according to any one of claims 1 to 7, wherein the first power amplifier comprises a first pin and a second pin;
the first pin is connected to the input end of the switching unit, and the first output end and the second output end are respectively connected to a positive electrode of the first speaker and a positive electrode of the second speaker; and
the second pin is connected to a negative electrode of the first speaker; and the second pin is connected to a negative electrode of the second speaker.

9. The circuit according to any one of claims 1 to 8, wherein the first power amplifier comprises a third pin and a fourth pin;
the third pin is connected to the input end of the switching unit, and the first output end and the second output end are respectively connected to the negative electrode of the first speaker and the negative electrode of the second speaker; and
the fourth pin is connected to the positive electrode of the first speaker; and the fourth pin is connected to the positive electrode of the second speaker.

10. The circuit according to any one of claims 1 to 9, wherein the circuit further comprises a second power amplifier and a third speaker, and the battery and the third speaker are both connected to the second power amplifier;
the second power amplifier is configured to amplify the audio; and
the third speaker is configured to play audio processed by the second power amplifier.

11. The circuit according to any one of claims 1 to 10, wherein the first speaker is located on a first side of a terminal device, the third speaker is located on a second side of the terminal device, the first side and the second side are two opposite sides, and the second speaker is located behind a display of the terminal device.

12. A terminal device, comprising the audio circuit according to any one of claims 1 to 11.

13. The terminal device according to claim 12, wherein the terminal device further comprises a microphone, and the microphone is configured to collect a sound signal.
